# EUROPEAN PATENT APPLICATION

(11) **EP 3 328 028 A1**
(43) Date of publication of application: **30.05.2018**
(21) Application number: 16789199.3
(22) Date of filing: 29.03.2016
(51) Int. Cl.: H04L 29/08

(54) **INDICATION METHOD AND APPARATUS FOR CONNECTION STATE OF SOFTWARE DEFINED NETWORK DEVICE AND CONTROLLER**

(30) Priority: 22.07.2015 CN 201510437127
(71) Applicant: ZTE Corporation, Shenzhen, Guangdong 518057 (CN)
(72) Inventor: LU, Huaxing, Shenzhen Guangdong 518057 (CN); LU, Qinyu, Shenzhen Guangdong 518057 (CN); CHEN, Yan, Shenzhen Guangdong 518057 (CN); YUAN, Tianhua, Shenzhen Guangdong 518057 (CN); JIN, Hao, Shenzhen Guangdong 518057 (CN)
(74) Representative: Nordmeyer, Philipp Werner
(86) International application number: PCT/CN2016/077741
(87) International publication number: WO 2016/177205

(57) **Abstract**

A method and an apparatus for indicating connection status between a software defined network device and a controller are disclosed. The method includes: transmitting, by the software defined network device, a transmission control protocol message for establishing a connection with the controller; and transmitting, by the software defined network device, a first indication instruction to a light emitting diode, abbreviated as LED, indicator on the software defined network device, in a case that a destination internet protocol address in the transmission control protocol message is an internet protocol address of the controller, and a destination port in the transmission control protocol message is a port of the controller, the first indication instruction instructing the LED indicator on the software defined network device to be in a first state of a first color. The method solves the problem that connection status between the software defined network device and the controller cannot be displayed visually, and achieves visual display of the connection status between the software defined network device and the controller.

## Description

### TECHNICAL FIELD

The present disclosure relates to the field of communications, and especially, to a method and an apparatus for indicating connection status between a software defined network device and a controller.

### BACKGROUND

A software defined network (abbreviated as SDN) is a new type of network architecture that separates data from control and is software-programmable. The SDN uses a centralized control plane and a distributed forwarding plane, which are separated from each other. The control plane performs centralized control over network devices on the forwarding pane using a control-forwarding communication interface, and provides flexible programmability. Control signaling traffic occurs between a controller and a network device, and is independent of data traffic generated by a communication product between terminals. The network device generates a forwarding table by accepting a control signaling, and data traffic processing is determined based on the forwarding table. Thus, it is no longer needed to use complex distributed network protocols for data forwarding.

The SDN architecture is not a specific network protocol, but a framework of network protocol architecture. The framework may include a plurality of interface protocols. For example, interaction between an SDN controller and an SDN switch may be implemented by using a southbound interface protocol such as OpenFlow, and interaction between a service application and the SDN controller may be implemented by using a northbound application programming interface (API).

However, so far there is no effective solution to the problem that the connection status between a software defined network (SDN) device and a controller cannot be displayed visually in the existing art.

### SUMMARY

A method and an apparatus for indicating connection status between a software defined network (SDN) device and a controller are provided, in order to at least solve the problem that the connection status between the SDN device and the controller cannot be displayed visually in the existing art.

According to an embodiment of the present disclosure, it is provided a method for indicating connection status between an SDN device and a controller, including:
transmitting, by the SDN device, a transmission control protocol (TCP) message for establishing a connection with the controller; and
transmitting, by the SDN device, a first indication instruction to a light emitting diode (LED) indicator on the SDN device, in a case that a destination internet protocol (IP) address in the TCP message is an IP address of the controller, and a destination port in the TCP message is a port of the controller, the first indication instruction instructing the LED indicator on the SDN device to be in a first state of a first color.

In an embodiment of the present disclosure, before transmitting, by the SDN device, the TCP message for establishing a connection with the controller, the method further includes:
transmitting, by the SDN device, a second indication instruction to the LED indicator on the SDN device, the second indication instruction instructing the LED indicator to be in a second state of the first color.

In an embodiment of the present disclosure, after transmitting, by the SDN device, the TCP message for establishing a connection with the controller, the method further includes:
receiving, by the SDN device, a first establishment message from the controller, and transmitting, by the SDN device, a third indication instruction to the LED indicator on the SDN device after the SDN device transmits a second establishment message to the controller based on the first establishment message, the third indication instruction instructing the LED indicator on the SDN device to be in a second state of a second color; and
transmitting, by the SDN device, a fourth indication instruction to the LED indicator on the SDN device in a case that the SDN device does not receive the first establishment message from the controller, the fourth indication instruction instructing the LED indicator on the SDN device to be in a second state of a third color.

In an embodiment of the present disclosure, after transmitting the second establishment message to the controller based on the first establishment message, the method further includes:
transmitting, by the SDN device, a fifth indication instruction to the LED indicator on the SDN device after the SDN device receives an echo request message transmitted from the controller, the fifth indication instruction instructing the LED indicator on the SDN device to be continuously in the second state of the second color;
transmitting, by the SDN device, a sixth indication instruction to the LED indicator on the SDN device in a case that the SDN device does not receive the echo request message transmitted from the controller, the sixth indication instruction instructing the LED indicator on the SDN device to be in a first state of the third color; and
transmitting, by the SDN device, a seventh indication instruction to the LED indicator on the SDN device after a time during which the SDN device does not receive the echo request message transmitted from the controller reaches a preset time threshold, the seventh indication instruction instructing the LED indicator on the SDN device to be in the second state of the second color.

In an embodiment of the present disclosure, after transmitting the second establishment message to the controller based on the first establishment message, the method further includes:
transmitting, by the SDN device, an eighth indication instruction to the LED indicator on the SDN device in a case that the SDN device exchanges a control message of a protocol with the controller, the eighth indication instruction instructing the LED indicator on the SDN device to be in a first state of the second color.

According to another embodiment of the present disclosure, it is provided an apparatus for indicating connection status between a software defined network (SDN) device and a controller, including a first transmission module and a second transmission module.

The first transmission module is configured to operate the SDN device to transmit a transmission control protocol (TCP) message for establishing a connection with the controller.

The second transmission module is configured to operate the SDN device to transmit a first indication instruction to a light emitting diode (LED) indicator on the SDN device, in a case that a destination internet protocol (IP) address in the TCP message is an IP address of the controller, and a destination port in the TCP message is a port of the controller. The first indication instruction instructs the LED indicator on the SDN device to be in a first state of a first color.

In an embodiment of the present disclosure, the apparatus further includes a third transmission module.

The third transmission module is configured to operate the SDN device to transmit a second indication instruction to the LED indicator on the SDN device before the SDN device transmits the TCP message for establishing a connection with the controller. The second indication instruction instructs the LED indicator to be in a second state of the first color.

In an embodiment of the present disclosure, the apparatus further includes a first reception module, a fourth transmission module and a fifth transmission module.

The first reception module is configured to operate the SDN device to receive a first establishment message from the controller after the SDN device transmits the TCP message for establishing a connection with the controller.

The fourth transmission module is configured to operate the SDN device to transmit a third indication instruction to the LED indicator on the SDN device after transmitting a second establishment message to the controller based on the first establishment message. The third indication instruction instructs the LED indicator on the SDN device to be in a second state of a second color.

The fifth transmission module is configured to operate the SDN device to transmit a fourth indication instruction to the LED indicator on the SDN device in a case that the SDN device does not receive the first establishment message from the controller after the SDN device transmits the TCP message for establishing a connection with the controller. The fourth indication instruction instructs the LED indicator on the SDN device to be in a second state of a third color.

In an embodiment of the present disclosure, the apparatus further includes a second reception module, a sixth transmission module, a seventh transmission module and an eighth transmission module.

The second reception module is configured to operate the SDN device to receive an echo request message transmitted from the controller after transmitting the second establishment message to the controller based on the first establishment message.

The sixth transmission module is configured to operate the SDN device to transmit a fifth indication instruction to the LED indicator on the SDN device after the SDN device receives the echo request message transmitted from the controller. The fifth indication instruction instructs the LED indicator on the SDN device to be continuously in the second state of the second color.

The seventh transmission module is configured to operate the SDN device to transmit a sixth indication instruction to the LED indicator on the SDN device in a case that the SDN device does not receive the echo request message transmitted from the controller. The sixth indication instruction instructs the LED indicator on the SDN device to be in a first state of the third color.

The eighth transmission module is configured to operate the SDN device to transmit a seventh indication instruction to the LED indicator on the SDN device after a time during which the SDN device does not receive the echo request message transmitted from the controller reaches a preset time threshold. The seventh indication instruction instructs the LED indicator on the SDN device to be in the second state of the second color.

In an embodiment of the present disclosure, the apparatus further includes a ninth transmission module.

The ninth transmission module is configured to operate the SDN device to transmit an eighth indication instruction to the LED indicator on the SDN device in a case that the SDN device exchanges a control message of a protocol with the controller after transmitting the second establishment message to the controller based on the first establishment message. The eighth indication instruction instructs the LED indicator on the SDN device to be in a first state of the second color.

According to the present disclosure, the SDN device transmits the TCP message for establishing a connection with the controller, and the SDN device transmits the first indication instruction to the LED indicator on the SDN device in a case that the destination IP address in the TCP message is the IP address of the controller and the destination port in the TCP message is the port of the controller, wherein the first indication instruction instructs the LED indicator on the SDN device to be in the first state of the first color, thereby solving the problem that the connection status between the SDN device and the controller cannot be displayed visually, and achieving visual display of the connection status between the SDN device and the controller.

### BRIEF DESCRIPTION OF DRAWINGS

The accompanying drawings described herein serve to provide a further understanding of the present disclosure and constitute a part of the present disclosure. Exemplary embodiments and the description thereof herein are used for explaining the present disclosure, rather than limiting the present disclosure. In the drawings:
FIG. 1 is a flowchart of a method for indicating connection status between a software defined network device and a controller according to an embodiment of the present disclosure;
FIG. 2 is a structural block diagram of an apparatus for indicating connection status between a software defined network device and a controller according to an embodiment of the present disclosure; and
FIG. 3 is a schematic flowchart illustrating connection status between a software defined network device and a controller according to an embodiment of the present disclosure.

### DETAILED DESCRIPTION

Hereinafter, the present disclosure will be described in detail with reference to the accompanying drawings and in conjunction with the embodiments. It should be noted that embodiments and features in the embodiments described in the present disclosure can be combined with each other, unless a conflict exists.

It should be noted that, the terms "first", "second", etc., in the description, claims and the above-mentioned drawings are used for distinguishing between similar objects, and not necessarily used for describing a particular order or sequence.

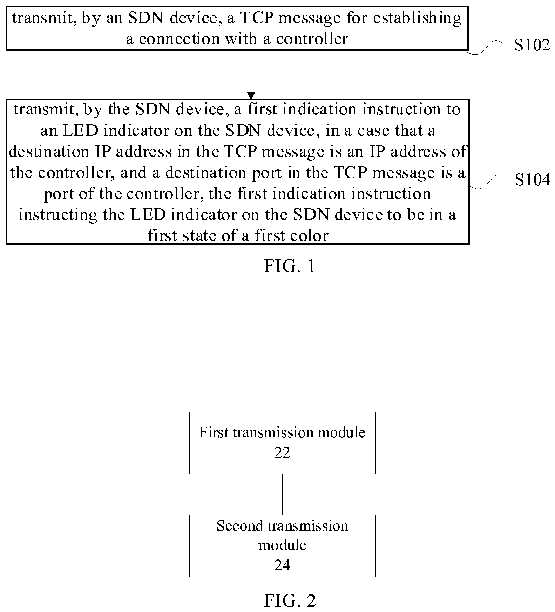

A method for indicating connection status between a software defined network (SDN) device and a controller is provided in the embodiments. FIG. 1 is a flowchart of a method for indicating connection status between a SDN device and a controller according to an embodiment of the present disclosure. As shown in FIG. 1, the method includes the following steps S102 and S104.

At the step S102, the SDN device transmits a transmission control protocol (TCP) message for establishing a connection with the controller.

At the step S104, the SDN device transmits a first indication instruction to a light emitting diode (LED) indicator on the SDN device, in a case that a destination internet protocol (IP) address in the TCP message is an IP address of the controller, and a destination port in the TCP message is a port of the controller. The first indication instruction instructs the LED indicator on the SDN device to be in a first state of a first color.

Through the above steps, after the SDN device transmits the TCP message for establishing a connection with the controller, the SDN device transmits the first indication instruction to the LED indicator on the SDN device, in a case that the destination IP address in the TCP message is the IP address of the controller and the destination port in the TCP message is the port of the controller, wherein the first indication instruction instructs the LED indicator on the SDN device to be in the first state of the first color, thereby solving the problem that the connection status between the SDN device and the controller cannot be displayed visually, and achieving visual display of the connection status between the SDN device and the controller.

In the embodiment, it should be noted that, a first color, a second color and a third color each may be any one of yellow, green and red, or may be another color; a first state and a second state each may be a steady light state, or may be a flashing light state, or may be another state.

In the embodiment, before the SDN device transmits the TCP message for establishing a connection with the controller, the SDN device may transmit a second indication instruction to the LED indicator on the SDN device. The second indication instruction instructs the LED indicator to be in a second state of the first color.

In the embodiment, after the SDN device transmits the TCP message for establishing a connection with the controller, the SDN device receives a first establishment message from the controller, and transmits a third indication instruction to the LED indicator on the SDN device after transmitting a second establishment message to the controller based on the first establishment message. The third indication instruction instructs the LED indicator on the SDN device to be in a second state of a second color.

The SDN device transmits a fourth indication instruction to the LED indicator on the SDN device in a case that the SDN device does not receive the first establishment message from the controller. The fourth indication instruction instructs the LED indicator on the SDN device to be in the second state of a third color.

In the embodiment, after transmitting the second establishment message to the controller based on the first establishment message, the SDN device transmits a fifth indication instruction to the LED indicator on the SDN device upon receipt of an echo request message transmitted from the controller. The fifth indication instruction instructs the LED indicator on the SDN device to be continuously in the second state of the second color.

The SDN device transmits a sixth indication instruction to the LED indicator on the SDN device in a case that the SDN device does not receive the echo request message transmitted from the controller. The sixth indication instruction instructs the LED indicator on the SDN device to be in a first state of a third color.

The SDN device transmits a seventh indication instruction to the LED indicator on the SDN device after a time during which the SDN device does not receive the echo request message transmitted from the controller reaches a preset time threshold. The seventh indication instruction instructs the LED indicator on the SDN device to be in the second state of the second color.

In the embodiment, after transmitting the second establishment message to the controller based on the first establishment message, the SDN device transmits an eighth indication instruction to the LED indicator on the SDN device in a case that the SDN device exchanges a control message of a protocol with the controller. The eighth indication instruction instructs the LED indicator on the SDN device to be in a first state of the second color.

An apparatus for indicating connection status between an SDN device and a controller is provided by the embodiment. The apparatus is used for implementing the above embodiments and implementations, and the explanations that have been made will not be repeated here. As used below, the term "module" may be a combination of software and/or hardware that can achieve an intended functionality. Although the apparatus described in the embodiments below may be implemented by software, implementations by hardware or a combination of software and hardware may be possible and conceived.

FIG. 2 is a structural block diagram of an apparatus for indicating connection status between an SDN device and a controller according to an embodiment of the present disclosure. As shown in FIG. 2, the apparatus includes a first transmission module 22 and a second transmission module 24.

The first transmission module 22 is configured to operate the SDN device to transmit a TCP message for establishing a connection with the controller.

The second transmission module 24 is configured to operate the SDN device to transmit a first indication instruction to an LED indicator on the SDN device, in a case that a destination IP address in the TCP message is an IP address of the controller, and a destination port in the TCP message is a port of the controller. The first indication instruction instructs the LED indicator on the SDN device to be in a first state of a first color.

Through the apparatus, after the SDN device transmits the TCP message for establishing a connection with the controller, the SDN device transmits the first indication instruction to the LED indicator on the SDN device, in a case that the destination IP address in the TCP message is the IP address of the controller and the destination port in the TCP message is the port of the controller, wherein the first indication instruction instructs the LED indicator on the SDN device to be in the first state of the first color, thereby solving the problem that the connection status between the SDN device and the controller cannot be displayed visually, and achieving visual display of the connection status between the SDN device and the controller.

In the embodiment, the apparatus may further include a third transmission module.

The third transmission module is configured to operate the SDN device to transmit a second indication instruction to the LED indicator on the SDN device before the SDN device transmits the TCP message for establishing a connection with the controller. The second indication instruction instructs the LED indicator to be in a second state of the first color.

In the embodiment, the apparatus may further include a first reception module, a fourth transmission module and a fifth transmission module.

The first reception module is configured to operate the SDN device to receive a first establishment message from the controller after the SDN device transmits the TCP message for establishing a connection with the controller.

The fourth transmission module is configured to operate the SDN device to transmit a third indication instruction to the LED indicator on the SDN device after the SDN device transmits a second establishment message to the controller based on the first establishment message. The third indication instruction instructs the LED indicator on the SDN device to be in a second state of a second color.

The fifth transmission module is configured to operate the SDN device to transmit a fourth indication instruction to the LED indicator on the SDN device in a case that the SDN device does not receive the first establishment message from the controller after the SDN device transmits the TCP message for establishing a connection with the controller. The fourth indication instruction instructs the LED indicator on the SDN device to be in a second state of a third color.

In the embodiment, the apparatus may further include a second reception module, a sixth transmission module, a seventh transmission module and an eighth transmission module.

The second reception module is configured to operate the SDN device to receive an echo request message transmitted from the controller after the SDN device transmits the second establishment message to the controller based on the first establishment message.

The sixth transmission module is configured to operate the SDN device to transmit a fifth indication instruction to the LED indicator on the SDN device after the SDN device receives the echo request message transmitted from the controller. The fifth indication instruction instructs the LED indicator on the SDN device to be continuously in the second state of the second color.

The seventh transmission module is configured to operate the SDN device to transmit a sixth indication instruction to the LED indicator on the SDN device in a case that the SDN device does not receive an echo request message transmitted from the controller. The sixth indication instruction instructs the LED indicator on the SDN device to be in a first state of the third color.

The eighth transmission module is configured to operate the SDN device to transmit a seventh indication instruction to the LED indicator on the SDN device after a time during which the SDN device does not receive an echo request message transmitted from the controller reaches a preset time threshold. The seventh indication instruction instructs the LED indicator on the SDN device to be in the second state of the second color.

In the embodiment, the apparatus may further include a ninth transmission module.

The ninth transmission module is configured to operate the SDN device to transmit an eighth indication instruction to the LED indicator on the SDN device in a case that the SDN device exchanges a control message of a protocol with the controller after the SDN device transmits the second establishment message to the controller based on the first establishment message. The eighth indication instruction instructs the LED indicator on the SDN device to be in a first state of the second color.

The present disclosure will be described in detail below in conjunction with embodiments and implementations.

OpenFlow is an SDN southbound interface protocol designed based on the concept of "flow" in the network. A conventional IP network is a packet-switched network based on data packet forwarding. A large number of data packets may be generated in one network communication. Although these data packets are inextricably linked, a conventional network device processes these data packets separately, and this greatly reduces the efficiency of processing. The above-mentioned problem can be well addressed if it is possible to abstract the data packets generated in this communication into a "flow" by extracting common features (such as a MAC address, an IP address, etc.) of the data packets so that a network device treats the data packets in a unified manner. After OpenFlow introduces the concept of "flow", the controller can deploy a strategy (called "a flow table" in OpenFlow) for devices on a data plane by using an interface provided by an OpenFlow protocol according to features of the first data package of a "flow" in a certain communication. In this case, subsequent traffic of this communication is matched and forwarded according to a corresponding flow table at the hardware level. Thus, a flexible network forwarding plane strategy is achieved.

A basic OpenFlow network includes a network controller (hereinafter referred to as controller) on a control plane and a network device on a forwarding plane. In the OpenFlow network, a method for forwarding a data message is implemented by using a flow table in the following manner: the controller controls multiple network devices on the forwarding plane through a standardized OpenFlow protocol, and each of the network devices receives and saves a flow table; the network device checks whether there is a matching flow entry in the flow table upon receipt of a data message transmitted from the network; if there is a matching flow entry in the flow table, the network device forwards the data message according to the action in the matching flow entry; if no matching flow entry is found, header information of the data message is encapsulated into a Packet-in message and sent to the controller; upon receipt of the Packet-in message, the controller calculates a path according to topology information saved by the controller, generates a Packet-out message and a Flow-mod message by using the obtained path, and transmits the Packet-out message and the Flow-mod message to the network device; the network device forwards the data massage according to the Packet-out message and establishes a flow entry according to the Flow-mod message.

The present embodiment provides a method for visualizing connection status between an SDN device and a controller. The method includes the following steps.

The SDN device is connected with the controller through a network cable or a fiber interface. An interface of the SDN device is provided with an LED indicator, and the LED indicator is initially configured to emit yellow steady light.

The LED indicator is configured to emit yellow flashing light, when the SDN device starts to transmit a TCP message for establishing a connection with the controller, a destination IP address in the TCP message is an IP address of the controller, and a destination port in the TCP message is a port of the controller.

The LED indicator on the SDN device is configured to emit green steady light, while the SDN device transmits a hello message to the controller after receiving a hello message transmitted from the controller and parsing out version information from the hello message. After the connection is established, the controller periodically transmits an echo request message to the SDN device.

The LED indicator on the SDN device is configured to emit red steady light, if the SDN device does not receive the hello message from the controller, or if the SDN device does not transmit a hello message to the controller due to a fault after receiving a hello massage transmitted from the controller.

The LED indicator is configured to emit green flashing light, when the SDN device negotiates with the controller successfully and the controller exchanges a control message (including a flow table, a group table, etc.) with the SDN device.

When the SDN device does not receive the echo request message within a specified time, the connection is determined to be interrupted, and the LED indicator is configured to emit red flashing light.

When a specified time has elapsed, the LED indicator is configured to be in the initial state, i.e., emit yellow steady light, and the SDN device restarts to establish a connection with the controller.

The present embodiment includes a method of visualizing connection-establishing status, connecting status, and connection-interrupted status between the SDN device and the controller.

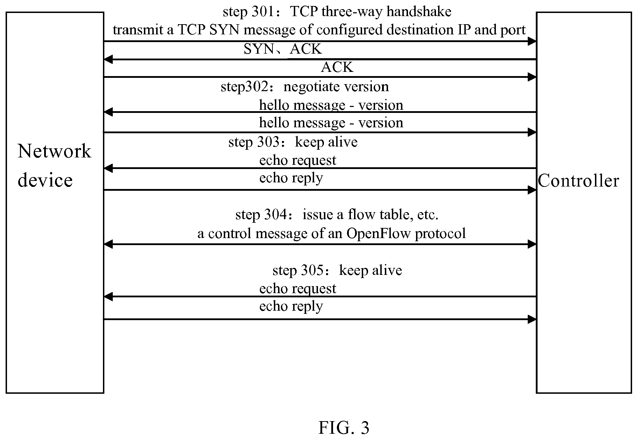

FIG. 3 is a schematic flowchart illustrating connection status between an SDN device and a controller according to an embodiment of the present disclosure. Reference is made to FIG. 3.

At step 301, the LED indicator is configured to emit yellow flashing light to indicate that the SDN device and the controller are connecting to each other, when the SDN device transmits a TCP message for connection establishment. In this step, three-way handshake of TCP occurs. Specifically, TCP synchronize sequence number (abbreviated as SYN) message of a configured destination IP and a configured destination port, and an acknowledgment number (abbreviated as ACK) are transmitted, and an ACK is received.

At step 302, the SDN device receives a hello message from the controller, parses out a version of an OpenFlow protocol, and then configures the LED indicator to emit green steady light while transmitting a hello message to the controller, the green steady light indicating a connection between the SDN device and the controller is established. If the SDN device does not receive the hello message from the controller, the LED indicator is configured to emit red steady light to indicate failing to establish a connection between the SDN device and the controller.

At step 303, the controller periodically transmits an echo request message to the SDN device, the SDN device transmits an echo reply message to the controller upon receipt of the echo request message, and the status of the LED indicator is not changed. If the SDN device does not receive the echo request message, or if the SDN device does not transmit the echo reply message after receiving the echo request message, the LED indicator is configured to emit red flashing light to indicate that the connection between the SDN device and the controller is interrupted. If this status lasts longer than a specified time, the LED indicator is configured to emit initial yellow steady light to indicate that the SDN device is not connected with the controller.

At step 304, a flow table is issued, and the LED indicator is configured to emit green flashing light to indicate that the SDN device is exchanging data with the controller when the SDN device exchanges an OpenFlow control message with the controller.

At step 305, the connection is kept alive, similar to step 303.

In the above embodiment, the LED indicator emits yellow steady light when the SDN device is not connected with the controller.

The LED indicator emits yellow flashing light when the SDN device and the controller are connecting to each other.

The LED indicator emits green steady light when the SDN device is connected to the controller successfully.

The LED indicator emits red steady light when the connection between the SDN device and the controller fails.

The LED indicator emits red flashing light when the connection between the SDN device and the controller is interrupted.

The LED indicator emits green flashing light when the SDN device exchanges an OpenFlow control message with the controller.

The exemplary embodiment can visually display the connection status between the SDN device and the controller by using the LED indicator on the device port.

Through the above description of the implementations, those skilled in the art can clearly understand that the method according to each of the above embodiments may be implemented by software and an optional universal hardware platform, and alternatively may also be implemented by hardware. However, in many cases, the former is a better implementation. Based on this understanding, the technical solutions according to the embodiments of the present disclosure as a whole, or the part of the technical solutions according to the embodiments of the present disclosure contributing to the existing art, may be embodied in the form of a computer software product. The computer software product may be stored in a storage medium (such as a ROM/RAM, a magnetic disk, an optical disk), and includes several instructions to enable a terminal device (which may be a mobile phone, a computer, a server, a network device, or the like) to execute the method according to each of the embodiments of the present disclosure.

An embodiment of the present disclosure provides a storage medium. Optionally, in the embodiment, the storage medium may be configured to store program code for executing the steps of the method according to each of the foregoing embodiments.

Optionally, in the present embodiment, the storage medium may include, but is not limited to, various media that can store program code, such as a USB flash disk, a read-only memory (ROM), a random access memory (RAM), a removable hard disk, a diskette, an optical disc, or the like.

Optionally, in the present embodiment, a processor may execute the steps of the method according to each of the foregoing embodiments according to the program code stored in the storage medium.

Obviously, those skilled in the art should understand that the above-described modules or steps of the present disclosure can be implemented by universal computing devices, and may be centralized on a single computing device or distributed on a network formed by multiple computing devices. Optionally, the modules or steps may be implemented with program code executable by a computing device, so that they may be stored in a storage device for execution by the computing device. In some cases, the steps shown or described herein may be performed in a different order, or may be embodied into individual integrated circuit modules, respectively. Alternatively, a plurality of modules or steps among them may be embodied into a single integrated circuit module. As such, the present disclosure is not limited to any specific combination of hardware and software.

The foregoing describes merely exemplary embodiments of the present disclosure and are not intended to limit the present disclosure. For those skilled in the art, the present disclosure may have various modifications and changes. Any modification, equivalent replacement, improvement, etc. within principle of the present disclosure should be encompassed in the protection scope of the present disclosure as defined in the appended claims.

### Industrial Applicability

Based on the above technical solutions provided in the embodiments of the present disclosure, the SDN device transmits the TCP message for establishing a connection with the controller, and the SDN device transmits the first indication instruction to the LED indicator on the SDN device in a case that the destination IP address in the TCP message is the IP address of the controller and the destination port in the TCP message is the port of the controller, wherein the first indication instruction instructs the LED indicator on the SDN device to be in the first state of the first color, thereby solving the problem that the connection status between the SDN device and the controller cannot be displayed visually, and achieving visual display of the connection status between the SDN device and the controller.

## Claims

1. A method for indicating connection status between a software defined network device and a controller, comprising:
transmitting, by the software defined network device, a transmission control protocol message for establishing a connection with the controller; and
transmitting, by the software defined network device, a first indication instruction to a light emitting diode, abbreviated as LED, indicator on the software defined network device, in a case that a destination internet protocol address in the transmission control protocol message is an internet protocol address of the controller, and a destination port in the transmission control protocol message is a port of the controller, the first indication instruction instructing the LED indicator on the software defined network device to be in a first state of a first color.

2. The method of claim 1, further comprising, before transmitting, by the software defined network device, the transmission control protocol message for establishing a connection with the controller:
transmitting, by the software defined network device, a second indication instruction to the LED indicator on the software defined network device, the second indication instruction instructing the LED indicator to be in a second state of the first color.

3. The method of claim 1, further comprising, after transmitting, by the software defined network device, the transmission control protocol message for establishing a connection with the controller:
receiving, by the software defined network device, a first establishment message from the controller, and transmitting, by the software defined network device, a third indication instruction to the LED indicator on the software defined network device after the software defined network device transmits a second establishment message to the controller based on the first establishment message, the third indication instruction instructing the LED indicator on the software defined network device to be in a second state of a second color; and
transmitting, by the software defined network device, a fourth indication instruction to the LED indicator on the software defined network device in a case that the software defined network device does not receive the first establishment message from the controller, the fourth indication instruction instructing the LED indicator on the software defined network device to be in a second state of a third color.

4. The method of claim 3, further comprising, after transmitting the second establishment message to the controller based on the first establishment message:
transmitting, by the software defined network device, a fifth indication instruction to the LED indicator on the software defined network device after the software defined network device receives an echo request message transmitted from the controller, the fifth indication instruction instructing the LED indicator on the software defined network device to be continuously in the second state of the second color;
transmitting, by the software defined network device, a sixth indication instruction to the LED indicator on the software defined network device in a case that the software defined network device does not receive the echo request message transmitted from the controller, the sixth indication instruction instructing the LED indicator on the software defined network device to be in a first state of the third color; and
transmitting, by the software defined network device, a seventh indication instruction to the LED indicator on the software defined network device after a time during which the software defined network device does not receive the echo request message transmitted from the controller reaches a preset time threshold, the seventh indication instruction instructing the LED indicator on the software defined network device to be in the second state of the second color.

5. The method of claim 3, further comprising, after transmitting the second establishment message to the controller based on the first establishment message:
transmitting, by the software defined network device, an eighth indication instruction to the LED indicator on the software defined network device in a case that the software defined network device exchanges a control message of a protocol with the controller, the eighth indication instruction instructing the LED indicator on the software defined network device to be in a first state of the second color.

6. An apparatus for indicating connection status between a software defined network device and a controller, comprising:
a first transmission module, configured to operate the software defined network device to transmit a transmission control protocol message for establishing a connection with the controller; and
a second transmission module, configured to operate the software defined network device to transmit a first indication instruction to a light emitting diode, abbreviated as LED, indicator on the software defined network device, in a case that a destination internet protocol address in the transmission control protocol message is an internet protocol address of the controller, and a destination port in the transmission control protocol message is a port of the controller, the first indication instruction instructing the LED indicator on the software defined network device to be in a first state of a first color.

7. The apparatus of claim 6, further comprising:
a third transmission module, configured to operate the software defined network device to transmit a second indication instruction to the LED indicator on the software defined network device before the software defined network device transmits the transmission control protocol message for establishing a connection with the controller, the second indication instruction instructing the LED indicator to be in a second state of the first color.

8. The apparatus of claim 6, further comprising:
a first reception module, configured to operate the software defined network device to receive a first establishment message from the controller after the software defined network device transmits the transmission control protocol message for establishing a connection with the controller;
a fourth transmission module, configured to operate the software defined network device to transmit a third indication instruction to the LED indicator on the software defined network device after transmitting a second establishment message to the controller based on the first establishment message, the third indication instruction instructing the LED indicator on the software defined network device to be in a second state of a second color; and
a fifth transmission module, configured to operate the software defined network device to transmit a fourth indication instruction to the LED indicator on the software defined network device in a case that the software defined network device does not receive the first establishment message from the controller after the software defined network device transmits the transmission control protocol message for establishing a connection with the controller, the fourth indication instruction instructing the LED indicator on the software defined network device to be in a second state of a third color.

9. The apparatus of claim 8, further comprising:
a second reception module, configured to operate the software defined network device to receive an echo request message transmitted from the controller after transmitting the second establishment message to the controller based on the first establishment message;
a sixth transmission module, configured to operate the software defined network device to transmit a fifth indication instruction to the LED indicator on the software defined network device after the software defined network device receives the echo request message transmitted from the controller, the fifth indication instruction instructing the LED indicator on the software defined network device to be continuously in the second state of the second color;
a seventh transmission module, configured to operate the software defined network device to transmit a sixth indication instruction to the LED indicator on the software defined network device in a case that the software defined network device does not receive the echo request message transmitted from the controller, the sixth indication instruction instructing the LED indicator on the software defined network device to be in a first state of the third color; and
an eighth transmission module, configured to operate the software defined network device to transmit a seventh indication instruction to the LED indicator on the software defined network device after a time during which the software defined network device does not receive the echo request message transmitted from the controller reaches a preset time threshold, the seventh indication instruction instructing the LED indicator on the software defined network device to be in the second state of the second color.

10. The apparatus of claim 8, further comprising:
a ninth transmission module, configured to operate the software defined network device to transmit an eighth indication instruction to the LED indicator on the software defined network device in a case that the software defined network device exchanges a control message of a protocol with the controller after transmitting the second establishment message to the controller based on the first establishment message, the eighth indication instruction instructing the LED indicator on the software defined network device to be in a first state of the second color.
